Europäisches Patentamt

European Patent Office

Office européen des brevets

(11) Veröffentlichungsnummer: **0 451 324 B1**

(12) **EUROPÄISCHE PATENTSCHRIFT**

(45) Veröffentlichungstag der Patentschrift: **01.06.94**

(21) Anmeldenummer: **90117728.7**

(22) Anmeldetag: **14.09.90**

(51) Int. Cl.5: **H02H 6/00**, H03K 17/08

(54) **Halbleiterschalter.**

(30) Priorität: **25.09.89 CH 3460/89**

(43) Veröffentlichungstag der Anmeldung:
**16.10.91 Patentblatt 91/42**

(45) Bekanntmachung des Hinweises auf die
Patenterteilung:
**01.06.94 Patentblatt 94/22**

(84) Benannte Vertragsstaaten:
**CH DE FR IT LI SE**

(56) Entgegenhaltungen:
**EP-A- 0 135 870        EP-A- 0 319 870
DE-A- 2 140 290        DE-A- 2 528 767
DE-B- 1 108 317        DE-B- 1 170 061
FR-A- 2 293 746        FR-A- 2 581 807**

(73) Patentinhaber: **ASEA BROWN BOVERI AG
Haselstrasse
CH-5401 Baden(CH)**

(72) Erfinder: **Hobelsberger, Max
Dorfstrasse 59
CH-5303 Würenlingen(CH)**

Rank Xerox (UK) Business Services
(3.10/3.09/3.3.3)

## Beschreibung

Technisches Gebiet

Halbleiterschalter mit einer Vorrichtung zur Messung der Sperrschichttemperatur eines laststromführenden Halbleiterventils.

Stand der Technik

Hierbei nimmt die Erfindung auf einen Stand der Technik von Temperaturmessverfahren Bezug, bei dem die Sperrschichttemperatur eines Halbleiterventils direkt mit einem am Halbleiterventil angebrachten Temperatursensor ermittelt wird. Bei diesem Verfahren kann die aktuelle Sperrschichttemperatur wegen der räumlichen Distanz zwischen Sperrschicht und Messstelle jedoch nur mit einer erheblichen zeitlichen Verzögerung ermittelt werden. Durch steile Verlustleistungsanstiege bedingte, rasche Temperaturänderungen sind überhaupt nicht erfassbar.

Es sind ferner Halbleiterschalter bekannt, bei denen der ein Halbleiterventil durchfliessende abzuschaltende Strom gemessen und, falls die Stromstärke einen zulässigen Maximalwert überschreitet, dieses Ventil mit einer vorgegebenen, teilweise noch von der Ausgangsspannung beeinflussbaren Verzögerung geöffnet wird (vgl. z.B. den Aufsatz von M. Raffay "UAF 1780 - Ein verlustarmer monolithischer Schaltbaustein" in Applikationsbericht 6, SGS-Thomson Leistungs Ics, Dezember 88.) Bei diesen Schaltern wird jedoch nicht die tatsächliche Sperrschichttemperatur ermittelt. Solche Schalter werden wegen der notwendigerweise auf den ungünstigsten Schaltfall abgestimmten Bemessung im allgemeinen meist zu früh geöffnet.

Darstellung der Erfindung

Die Erfindung, wie sie in Patentanspruch 1 definiert ist, löst die Aufgabe, in einfacher Weise einen Halbleiterschalter der eingangs genannten Art zu schaffen, welcher gegen Kurzschluss und Ueberlast gesichert ist und mit dem zugleich auch kapazitiv wirkende Lasten problemlos beherrscht werden können.

Der Halbleiterschalter nach der Erfindung zeichnet sich dadurch aus, dass aufgrund der Messung der im Halbleiterventil umgesetzten Leistung sowie der elektrischen Nachbildung des thermischen Verhaltens des Halbleiterventils in einem der Leistungsmessung nachgeschalteten elektrischen Netzwerk praktisch verzögerungsfrei und mit beliebiger Genauigkeit die aktuelle Temperatur der Sperrschicht des Halbleiterventils ermittelt werden kann. Insbesondere können durch Ueber- oder Kurzschlussströme bedingte krasse Temperaturerhöhungen rasch erfasst und signalisiert werden. Hierbei macht sich die Erfindung die Erkenntnis zunutze, dass eine Leistungsmessung am Halbleiterventil eine geeignete Eingangsgrösse liefert für ein das thermische Verhalten des Halbleitersystems nachbildendes elektrisches Modell, in dem äusserst rasch und mit beliebiger Genauigkeit aus dieser Eingangsgrösse eine der zu ermittelnden Sperrschichttemperatur proportionale elektrische Ausgangsgrösse gewonnen werden kann.

Der Halbleiterschalter nach der Erfindung besteht aus vergleichsweise wenigen und kommerziell leicht erhältlichen Bauteilen. Er kann daher äusserst preiswert gefertigt werden und ist trotzdem gut gegen Kurzschluss und Ueberlast gesichert. Zudem kann er problemlos auch mit kapazitiv wirkenden Lasten betrieben werden.

Kurze Beschreibung der Zeichnung

Die Erfindung wird nachfolgend anhand eines in der Zeichnung beschriebenen Ausführungsbeispiels näher erläutert. Hierbei zeigt:

Fig. 1    ein Schaltbild einer Vorrichtung zur Messung der Sperrschichttemperatur eines laststromführenden Halbleiterventils,

Fig. 2    ein Blockschaltbild eines Halbleiterschalters nach der Erfindung, und

Fig. 3    ein Einzelheiten angebendes Schaltbild des Halbleiterschalters gemäss Fig. 2.

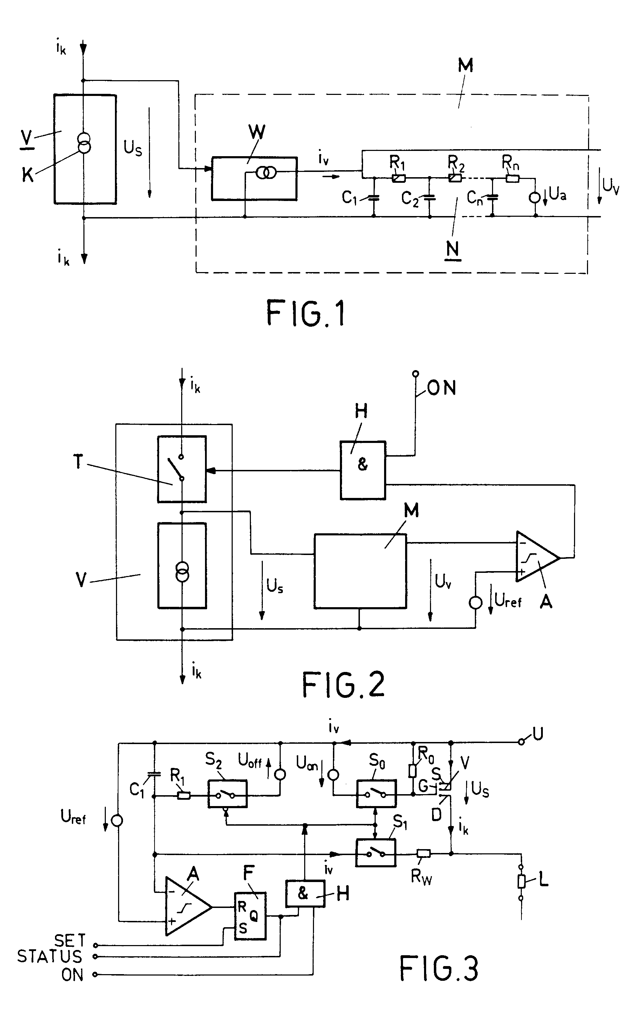

Bei der in Fig. 1 dargestellten Schaltung bezeichnet V ein von einem Laststrom durchflossenes Halbleiterventil, etwa einen Transistor. Im Falle eines Kurzschlusses oder eines Ueberstroms im Lastkreis wirkt dieses Halbleiterventil V als Konstantstromquelle K und führt dann unabhängig von der über ihm abfallenden Ventilspannung $U_S$ konstanten Strom $i_K$. Die im Halbleiterventil V anfallende Verlustleistung ist dann im wesentlichen proportional der Ventilspannung $U_S$.

Die Ventilspannung $U_S$ wird einem Wandelelement W zugeführt, etwa einem ohmschen Widerstand, in dem sie in einen ihr proportionalen und somit der Verlustleistung direkt proportionalen Strom $i_V$, mit $i_V = I \cdot U_S$, wobei I ein Proportionalitätsfaktor ist, gewandelt wird. Der Strom $i_V$ wird dem Eingang eines Netzwerkes N zugeführt, welches eine Serienschaltung von RC-Gliedern $R_1 C_1$, $R_2 C_2$, ..., $R_n C_n$ mit Widerständen $R_1$, $R_2$, ... $R_n$ und Kapazitäten $C_1$, $C_2$, ..., $C_n$ ist, sowie eine Referenzspannungsquelle der Spannung $U_a$ aufweist.

Das Netzwerk N ist derart beschaffen, dass es das thermische System des Halbleiterventils V elektrisch nachbildet. Das thermische System eines Halbleiterventils V ist im wesentlichen bestimmt durch die Wärmekapazitäten und die Wärmeleitfähigkeiten seiner Bestandteile. Dies lässt sich in guter Näherung bereits durch ein Netzwerk mit nur einem RC-Glied elektrisch nachbilden, wobei dieses eine RC-Glied eine der Zeitkonstante der thermischen Abkühlung des Halbleiterventils V entsprechende Zeitkonstante aufweist. Eine verbesserte Nachbildung wird durch eine Serienschaltung von zwei oder mehr RC-Gliedern erreicht sowie durch Einfügung der Referenzspannungsquelle, deren Spannung Ua so gewählt ist, dass in das Netzwerk eine der Umgebungstemperatur $T_A$ entsprechende Spannung eingespeist wird ($U_a = k \cdot T_A$, mit K als Proportionalitätsfaktor.

In diesem Modell werden die einzelnen Widerstände $R_i$, i = 1, ..., n bzw. Kapazitäten $C_i$, i = 1, ..., n, derart gewählt, dass gilt:

$$R_i[\Omega] = m \cdot R_i^{th}[W/°C]$$
$$C_i[F] = -\frac{1}{m} C_i^{th}[°C/J]$$

mit i = 1, ..., n, wobei

$R_i^{th}$ die Wärmeleitfähigkeit zwischen zwei Bestandteilen des Halbleiterventils V, etwa zwischen der Sperrschicht und dem Ventilgehäuse,

$C_i$ die Wärmekapazität eines Bestandteils des Halbleiterventils V, etwa der Sperrschicht, und

m einen Modellfaktor, bedeuten.

In diesem elektrischen Netzwerk wird nun aus dem leistungsproportionalen Stromeingangssignal $i_V$ eine Ausgangsspannung $U_V$ gebildet, welche proportional ist mit dem Proportionalitätsfaktor k der aktuellen Sperrschichttemperatur $T_J$ ($U_V = k \cdot T_J$). Hierbei bestimmt sich der Faktor k aus den bekannten Werten des konstanten Ventilstroms $i_K$, des Proportionalitätsfaktors l und des Modellfaktors m zu

$$k = (l \cdot m) / i_K$$

Ein besonderer Vorteil des zuvor beschriebenen Verfahrens und Vorrichtung zur Durchführung dieses Verfahrens ist darin zu sehen, dass die Sperrschichttemperatur im Falle von Ueber- oder Kurzschlussströmen praktisch verzögerungsfrei und mit hoher Genauigkeit ermittelt werden kann, und dass hierbei die Leistungsmessung durch Ausnutzung der bei Halbleiterventilen meist vorhandenen oder aber herbeigeführten Eigenschaft, bei Ueberstrom oder Kurzschluss als Konstantstromquelle zu wirken, im wesentlichen auf eine Spannungsmessung reduziert ist. Grundsätzlich ist es aber auch möglich, bei der Bestimmung der Sperrschichttemperatur $T_J$ sowohl den durch das Halbleiterventil V fliessenden Strom als auch die darüber abfallende Spannung zu messen und ein hieraus ermitteltes, der im Halbleiterventil V anfallenden Verlustleistung proportionales Signal dem Netzwerk N zuzuführen.

In Fig. 2 ist in einem Blockschaltbild dargestellt, wie die zuvor beschriebene, als Block M dargestellte Vorrichtung U zur Durchführung des erfindungsgemässen Temperaturmessverfahrens verwendet wird, um ein als Halbleiterschalter ausgebildetes Halbleiterventil V bei Ueberlast oder Kurzschluss gegen Beschädigung durch zu starke Erhitzung zu schützen. Analog zur Vorrichtung gemäss Fig. 1 wird die über dem Halbleiterventil V bei dessen Betrieb als Konstantstromquelle K abfallende Ventilspannung $U_S$ der Temperaturmessvorrichtung M zugeführt, in dieser Vorrichtung entsprechend Fig. 1 im Wandelelement W in einen leistungsproportionalen Strom gewandelt und dieser Strom dem Netzwerk N zwecks Bildung der sperrschichttemperaturproportionalen Ausgangsspannung $U_V$ zugeführt. Die Ausgangsspannung $U_V$ wird einem ersten Eingang eines Grenzwertvergleichers A zugeführt. Am zweiten Eingang des Grenzwertvergleichers A steht eine in einer Referenzspannungsquelle erzeugte Spannung $U_{ref}$ an. Diese Spannung ist gerade so gross, dass die ihr entsprechende Sperrschichttemperatur des Halbleiterventils V noch zulässig ist. Ueberschreitet die Ausgangsspannung $U_V$ die Spannung $U_{ref}$, so wird die zulässige Sperrschichttemperatur im Halbleiterventil V überschritten, der Grenzwertvergleicher gibt dann über ein mit einem Steuersignal ON verknüpfendes UND-Glied H ein Ausschaltsignal an eine Schaltfunktion T des Halbleiterventils V ab.

In Fig. 3 ist nun ein Schaltbild einer praktischen Ausführungsform des Halbleiterschalters gemäss Fig. 2 dargestellt. Hierbei ist als Halbleiterventil V ein Feldeffekt-Transistor vorgesehen, dessen Sourceelektrode S mit einer Speisespannungsquelle U, dessen Drainelektrode D mit einer Last L und dessen Gateelektrode G einerseits über einen beispielsweise als Transistor ausgebildeten Schalter $S_0$ mit einer Spannungsquelle der Spannung $U_{on}$ und andererseits über einen Widerstand $R_0$ mit der Speisespannungsquelle U verbunden ist. Parallel zum Halbleiterventil V ist eine Reihenschaltung des als ohmscher Widerstand $R_W$ ausgebildeten Wandelelementes W, eines beispielsweise als Transistor ausgebildeten Schalters $S_1$ und der Kapazität $C_1$ des Netzwerkes N der Temperaturmessvorrichtung M angeordnet. Parallel zur Kapazität $C_1$ ist eine Reihenschaltung des Widerstandes $R_1$ des Netzwerkes N der Temperaturmessvorrichtung, eines beispielsweise als Transistor ausgebildeten Schalters $S_2$ und einer Spannungsquelle der Spannung $U_{off}$ gelegt.

Bei diesem Halbleiterschalter sind im Zustand "Schalter geöffnet" die Schalter $S_0$ und $S_1$ geöffnet, hingegen ist der invertiert angesteuerte Schalter $S_2$ geschlossen. Das Halbleiterventil V sperrt in dieser Phase. Die Source-Gate-Spannung ist Null.

Die Kapazität $C_1$ wird über den Widerstand $R_1$ mit einer Zeitkonstante $T = R_1 \cdot C_1$, die entsprechend der Abkühlkonstante des Halbleiterventils V gewählt ist, auf die Spannung $U_{off}$ umgeladen. Hierbei wird die wegen des geöffneten Halbleiterventils V erfolgende Abkühlung der Sperrschicht des Halbleiterventils V elektrisch nachgebildet.

Im Zustand "Schalter geschlossen " sind die Schalter $S_0$ und $S_1$ geschlossen, der invertiert angesteuerte Schalter $S_2$ ist hingegen geöffnet. Das Halbleiterventil V wird mit der Spannung $U_{on}$ aufgesteuert, wodurch es bei niedrigen Lastströmen als ohmscher Widerstand mit bekanntem Minimal- und Maximalwert wirkt, bei hohen Strömen jedoch als Stromquelle mit bekanntem Maximalstrom arbeitet. Diese Arbeitsweise ist besonders ausgeprägt bei einem als MOSFET ausgebildeten Halbleiterventil V, da dort die den Drainstromverlauf in Funktion des Spannungsabfalls über das Halbleiterventil festlegenden Kennlinien zunächst linear ansteigen und sich dann in einem scharfen Knick als Parallele zu der die Spannung auftragende Abszisse erstrecken.

Bei Ueberlast oder Kurzschluss wird im Zustand "Schalter geschlossen" die Sperrschichttemperatur $T_J$ gemäss dem Verfahren nach der Erfindung gemessen. Hierbei arbeitet das Halbleiterventil V als Konstantstromquelle und wandelt der als Wandelelement wirkende Widerstand $R_W$ die über dem Halbleiterventil abfallende Spannung $U_S$ in den der im Ventil umgesetzten Leistung proportionalen Strom $i_V$ um. Hierbei ist $i_V$ bei hohen Verlustleistungsspitzen annähernd direkt proportional der im Ventil V erzeugten Leistung, da die Spannung über der bei Fliessen des Stromes $i_V$ aufgeladenen und hierbei das thermische Verhalten des Ventils elektrisch nachbildenden Kapazität $C_1$ gegenüber der am Ventil abfallenden Spannung $U_S$ bei hoher Verlustleistung vernachlässigt werden kann.

Sobald die Kapazität $C_1$ von der Spannung $U_{off}$ auf eine Spannung aufgeladen ist, die die Spannung $U_{ref}$ der Referenzquelle überschreitet, wird ein Flipflop F über den nun aktivierten Grenzwertvergleicher A rückgesetzt und wird über das UND-Glied H ein Ausschaltsignal an die Steuerelektroden der Schalter $S_0$, $S_1$ und $S_2$ ausgegeben, wodurch der Schalter $S_2$ geschlossen und die Schalter $S_0$ und $S_1$ geöffnet werden. Als Folge davon sperrt nun das Halbleiterventil V und ist vor weiterer Erwärmung geschützt.

Mittels eines Signaleingangs SET kann das Flipflop wieder gesetzt werden und können Wiedereinschaltversuche gestartet werden, während mittels eines Signalausgangs STATUS ein Ueberstrom und Kurzschluss angezeigt werden kann.

Bei hinreichend kleinen Strömen wirkt im Verlaufe des Zustands "Schalter geschlossen" das Ventil V als ohmscher Widerstand, die maximal erreichbare Sperrschichttemperatur wird in diesem thermisch quasistationären Zustand durch die Spannung $U_{ref}$ bestimmt. Auf steile Verlustleistungsanstiege kann äusserst schnell reagiert werden, da die Kapazität $C_1$ weitgehend umgeladen ist.

**Patentansprüche**

1. Halbleiterschalter mit einer Vorrichtung zur Messung der Sperrschichttemperatur eines laststromführenden Halbleiterventils (V), enthaltend ein das thermische Verhalten des Halbleiterventils (V) elektrisch nachbildendes Netzwerk (N) mit mindestens einem RC-Glied, ein zwischen dem Halbleiterventil (V) und dem Netzwerk (N) vorgesehenes Wandelelement (W) zur Erzeugung eines der im Halbleiterventil (V) umgesetzten Verlustleistung proportionalen Stromes ($i_V$) und einen Grenzwertvergleicher (A), dessen erster Eingang mit dem Ausgang des Netzwerkes (N) verbunden ist, an dessen zweitem Eingang ein einer zulässigen Sperrschichttemperatur proportionales Signal ansteht und dessen Ausgang auf eine den Laststrom im Halbleiterventil (V) steuernde Elektrode (G) wirkt, dadurch gekennzeichnet, dass das Wandelelement (W) als ohmscher Widerstand ($R_W$) ausgebildet ist, dass parallel zum Halbleiterventil (V) eine Reihenschaltung des als ohmscher Widerstand ($R_W$) ausgebildeten Wandelelementes (W), eines ersten Schaltelementes ($S_1$) und einer Kapazität ($C_1$) des Netzwerkes (N) geschaltet ist, dass parallel zur Kapazität ($C_1$) eine Reihenschaltung eines ohmschen Widerstandes ($R_1$) des Netzwerks (N), eines zweiten Schaltelements ($S_2$) und einer ersten Spannungsquelle ($U_{off}$) liegt, und dass die den Laststrom steuernde Elektrode (G) über ein drittes Schaltelement ($S_0$) mit einer zweiten Spannungsquelle ($U_{on}$) verbunden ist.

2. Halbleiterschalter nach Anspruch 1, dadurch gekennzeichnet, dass das Halbleiterventil (V) als Feldeffekttransistor ausgebildet ist.

3. Halbleiterschalter nach einem der Ansprüche 1 oder 2, dadurch gekennzeichnet, dass der Ausgang des Grenzwertvergleichers (A) auf Schaltorgane des ersten, zweiten und dritten Schaltelementes ($S_1$, $S_2$, $S_0$) wirkt.

4. Vorrichtung nach einem der Ansprüche 1 bis 3, dadurch gekennzeichnet, dass das Netzwerk eine Serienschaltung von RC-Gliedern enthält.

**5.** Vorrichtung nach Anspruch 4, dadurch gekennzeichnet, dass das Netzwerk (N) eine die Umgebungstemperatur des Halbleiterventils (V) elektrisch nachbildende Spannungsquelle ($U_a$) aufweist.

## Claims

**1.** Semiconductor switch having a device for measuring the depletion layer temperature of a semiconductor valve (V) which carries the load current, containing a network (N) which electrically models the thermal behaviour of the semiconductor valve (V) and has at least one RC element, a converting element (W) which is provided between the semiconductor valve (V) and the network (N) in order to produce a current ($i_V$) which is proportional to the power loss converted in the semiconductor valve (V), and a limit-value comparator (A) whose first input is connected to the output of the network (N), to whose second input a signal which is proportional to a permissible depletion layer temperature is applied and whose output acts on an electrode (G) which controls the load current in the semiconductor valve (V), characterized in that the converting element (W) is constructed as a non-reactive resistor ($R_W$), in that a series circuit comprising the converting element (W) which is constructed as a non-reactive resistor ($R_W$), a first switching element ($S_1$) and a capacitance ($C_1$) of the network (N) is connected in parallel with the semiconductor valve (V), in that a series circuit comprising a non-reactive resistor ($R_1$) of the network (N), a second switching element ($S_2$) and a first voltage source ($U_{off}$) is connected in parallel with the capacitance ($C_1$), and in that the electrode (G) which controls the load current is connected via a third switching element ($S_0$) to a second voltage source ($U_{on}$).

**2.** Semiconductor switch according to Claim 1, characterized in that the semiconductor valve (V) is constructed as a field-effect transistor.

**3.** Semiconductor switch according to one of Claims 1 or 2, characterized in that the output of the limit-value comparator (A) acts on switching devices of the first, second and third switching element ($S_1$, $S_2$, $S_0$).

**4.** Device according to one of Claims 1 to 3, characterized in that the network contains a series circuit of RC elements.

**5.** Device according to Claim 4, characterized in that the network (N) has a voltage source ($U_a$)

which electrically models the environmental temperature of the semiconductor valve (V).

## Revendications

**1.** Interrupteur à semi-conducteur avec un dispositif de mesure de la température de la couche de barrage d'une valve à semi-conducteur (V) traversée par un courant de charge, contenant un réseau (N) reproduisant électriquement le comportement thermique de la valve à semi-conducteur (V) avec au moins une combinaison RC, un élément transformateur (W) prévu entre la valve à semi-conducteur (V) et le réseau (N) pour la production d'un courant ($i_V$) proportionnel aux pertes de puissance transformées dans la valve à semi-conducteur (V) et un comparateur de valeur limite (A), dont la première entrée est reliée à la sortie du réseau (N), dont la seconde entrée reçoit un signal proportionnel à une température autorisée de la couche de barrage et dont la sortie agit sur une électrode (G) commandant le courant de charge dans la valve à semiconducteur (V), caractérisé en ce que l'élément transformateur (W) est conçu comme une résistance ohmique ($R_W$), que, parallèllement à la valve à semi-conducteur (V), est connecté un montage en série de l'élément transformateur (W), conçu comme une résistance ohmique, d'un premier élément de commutation ($S_1$) et d'une capacité ($C_1$) du réseau (N), que, parallèlement à la capacité ($C_1$) est connecté un montage en série d'une résistance ohmique ($R_1$) du réseau (N), d'un second élément de commutation ($S_2$) et d'une première source de tension ($U_{off}$) et que l'électrode (G) commandant le courant de charge est reliée, par l'intermédiaire d'un troisième élément de commutation ($S_0$), à une seconde source de tension ($U_{on}$).

**2.** Interrupteur à semi-conducteur selon la revendication 1, caractérisé en ce que la valve à semiconducteur (V) se présente comme un transistor à effet de champ.

**3.** Interrupteur à semi-conducteur selon l'une ou l'autre des revendications 1 ou 2, caractérisé en ce que la sortie du comparateur de valeur limite (A) agit sur les organes de commutation du premier, du deuxième et du troisième élément de commutation ($S_1$, $S_2$, $S_0$).

**4.** Dispositif selon l'une quelconque des revendications 1 à 3, caractérisé en ce que le réseau contient un montage en série de combinaisons RC.

5. Dispositif selon la revendication 4, caractérisé en ce que le réseau (N) présente une source de tension ($U_a$) reproduisant électriquement la température ambiante de la valve à semi-conducteur (V).

FIG.1

FIG.2

FIG.3